# EUROPEAN PATENT APPLICATION

(11) **EP 4 718 984 A2**
(43) Date of publication of application: **01.04.2026**
(21) Application number: 25202825.3
(22) Date of filing: 17.09.2025
(51) Int. Cl.: H10D 62/10, H10D 30/00, H10D 84/01, H10D 84/83, H10D 84/03

(54) **CELL ARCHITECTURE WITH FORKSHEET AND GATE-ALL-AROUND DEVICES**

(30) Priority: 27.09.2024 US 202418899521
(71) Applicant: Intel Corporation, Santa Clara, CA 95054 (US)
(72) Inventor: CHU, Tao, Portland, 97229 (US); KOH, Shao-Ming, Mountain View, 94041 (US); TIWARI, Vishal, Hillsboro, 97123 (US); YEUNG, Chun Wing, Portland, 97229 (US); XU, Guowei, Portland, 97229 (US); LUO, Yanbin, Portland, 97229 (US); PACKAN, Paul A., Hillsboro, 97124 (US); LIN, Chung-Hsun, Portland, 97229 (US); MURTHY, Anand, Portland, 97229 (US)
(74) Representative: 2SPL Patentanwälte PartG mbB

(57) **Abstract**

Techniques are provided herein to form semiconductor devices having cells that include both forksheet devices and GAA devices to increase cell performance. The techniques can be used in any number of integrated circuit applications and are particularly useful with respect to logic and memory cells. The dielectric spine of the forksheet devices extends in a first direction across the cell and also acts as a gate cut between the GAA devices. Accordingly, forksheet devices are formed on one side of the cell while GAA devices are formed on the opposite side of the cell. Semiconductor material from the nanosheets and nanoribbons has a tapering width (along a second direction orthogonal to the first direction) within a transition zone between the different sides of the cell.

## Description

### BACKGROUND

As integrated circuits continue to scale downward in size, a number of challenges arise. For instance, reducing the size of memory and logic cells is becoming increasingly more difficult, particularly given competing interests in a relatively small amount of space. For instance, repeating units of devices, often called cells or standard cells, can impose limitations on the arrangement of certain transistor structures that fail to maximize the available footprint on a given die. Accordingly, there remain a number of non-trivial challenges with respect to designing layout of various cells of the integrated circuit structure for improved PPA (power, performance, and area) performance.

### BRIEF DESCRIPTION OF THE DRAWINGS

Figure 1A is a plan view of a cell layout having both forksheet and gate-all-around (GAA) devices, in accordance with an embodiment of the present disclosure.
Figure 1B is a plan view of the tall cell from Figure 1A showing various dimensions of different features of the cell layout, in accordance with an embodiment of the present disclosure.
Figures 2A and 2B are cross-section views across portions of the cell layout from Figures 1A and 1B, in accordance with some embodiments of the present disclosure.
Figures 3A and 3B are cross-sectional views that illustrate one stage in an example process for forming a cell layout having forksheet devices and GAA devices, in accordance with some embodiments of the present disclosure.
Figures 4A and 4B are cross-sectional views that illustrate another stage in the example process for forming a cell layout having forksheet devices and GAA devices, in accordance with some embodiments of the present disclosure.
Figures 5A and 5B are cross-sectional views that illustrate another stage in the example process for forming a cell layout having forksheet devices and GAA devices, in accordance with some embodiments of the present disclosure.
Figures 6A and 6B are cross-sectional views that illustrate another stage in the example process for forming a cell layout having forksheet devices and GAA devices, in accordance with some embodiments of the present disclosure.
Figures 7A and 7B are cross-sectional views that illustrate another stage in the example process for forming a cell layout having forksheet devices and GAA devices, in accordance with some embodiments of the present disclosure.
Figures 8A and 8B are cross-sectional views that illustrate another stage in the example process for forming a cell layout having forksheet devices and GAA devices, in accordance with some embodiments of the present disclosure.
Figures 9A and 9B are cross-sectional views that illustrate another stage in the example process for forming a cell layout having forksheet devices and GAA devices, in accordance with some embodiments of the present disclosure.
Figure 10 illustrates a cross-section view of a chip package containing one or more semiconductor dies, in accordance with some embodiments of the present disclosure.
Figure 11 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form semiconductor devices having cells that include both a forksheet device and a gate-all-around (GAA) device to increase cell performance. The techniques can be used in any number of integrated circuit applications and are particularly useful with respect to logic and memory cells. The dielectric spine of the forksheet devices extends in a first direction across the cell and also acts as a gate cut between the GAA devices. Accordingly, one or more forksheet devices are formed on one side of the cell while one or more GAA devices are formed on the opposite side of the cell. Semiconductor material from the nanosheets and nanoribbons (or other such semiconductor bodies) has a tapering width (along a second direction orthogonal to the first direction) within a transition zone between the different sides of the cell. Numerous variations and embodiments will be apparent in light of this disclosure.

### General Overview

As previously noted above, there remain a number of non-trivial challenges with respect to formation of various semiconductor structures. Forksheet devices (also known as forkFET devices) include a dielectric spine extending down the middle of the nanoribbons, thus splitting the nanoribbons into nanosheets on either side of the dielectric spine. The nanosheets extend along a first direction between source and drain regions. GAA devices include nanoribbons extending along the first direction between source and drain regions while a gate structure extends in a second direction substantially orthogonal to the first direction around all sides of the nanoribbons. Standard cell architectures include either forksheet devices or GAA devices. However, the performance of the transistors of the cell is limited by the footprint of the cell and the power that can be delivered over a given area. Limiting the cell to one type of transistor architecture may inhibit the ability to maximize or otherwise improve the cell's performance potential.

Thus, and in accordance with an embodiment of the present disclosure, techniques are provided herein to form a cell architecture with both forksheet and GAA devices. This allows for an increase in the overall cell performance when compared to similarly sized cells having only forksheet devices or only GAA devices. According to some embodiments, one or more forksheet devices are formed on one side of the cell, with one or more GAA devices formed on the other side of the cell. The dielectric spine of the one or more forksheet devices extends across the cell between the two sides and acts as a gate cut between adjacent GAA devices. The semiconductor fin patterns across the cell include at least one fin that tapers in width across the cell to facilitate forming one or more forksheet devices on one side and one or more GAA devices on the other side. In some embodiments, a central fin extending across the cell along a first direction provides a wide-channel GAA device on one side of the cell and splits into separate channels of two different forksheet devices on the opposite side of the cell.

According to an embodiment, an integrated circuit includes a first semiconductor device having a first semiconductor region extending from a first source or drain region in a first direction and a first gate structure extending in a second direction over the first semiconductor region, a second semiconductor device having a second semiconductor region extending in the first direction from a second source or drain region and a second gate structure extending in the second direction over the second semiconductor region, and a dielectric wall having a first section extending in the first direction adjacent to and contacting the first semiconductor region, and a second section extending in the first direction adjacent to but not contacting the second semiconductor region. The second gate structure is between the second semiconductor region and the second section of the dielectric wall along the second direction.

According to an embodiment, an electronic device includes a chip package having one or more dies. At least one of the one or more dies includes a first semiconductor region extending from a first source or drain region in a first direction, a first gate structure extending over the first semiconductor region in a second direction, a second semiconductor region extending in the first direction from a second source or drain region, a second gate structure extending in the second direction over the second semiconductor region, and a dielectric wall having a first section extending in the first direction adjacent to and contacting the first semiconductor region, and a second section extending in the first direction adjacent to but not contacting the second semiconductor region. The second gate structure is between the second semiconductor region and the second section of the dielectric wall along the second direction.

According to another embodiment, an integrated circuit includes a first semiconductor device having a first semiconductor region extending from a first source or drain region in a first direction and a first gate structure extending in a second direction over the first semiconductor region, a second semiconductor device having a second semiconductor region extending in the first direction from a second source or drain region and a second gate structure extending in the second direction over the second semiconductor region, a dielectric wall extending in the first direction between the first semiconductor region and the second semiconductor region and between the first source or drain region and the second source or drain region, and a third semiconductor device having a third semiconductor region extending in the first direction from a third source or drain region and a third gate structure extending in the second direction over the third semiconductor region. The second source or drain region is adjacent to the first source or drain region along the second direction. The first semiconductor region extends in the first direction from the first source or drain region to the third source or drain region, and the second semiconductor region extends in the first direction from the second source or drain region to the third source or drain region.

The techniques can be used with any type of non-planar transistors, including finFETs (sometimes called double-gate transistors, or tri-gate transistors), or nanowire and nanoribbon transistors (sometimes called gate-all-around transistors), or forkFETs to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process), or any other gate formation process. Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of both a forksheet device and a GAA device within the same repeating cell architecture. Such tools may be used to show a dielectric spine extending between one or more forksheet devices that continues on to also act as a gate cut between one or more GAA devices. Numerous configurations and variations will be apparent in light of this disclosure.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

### Architecture

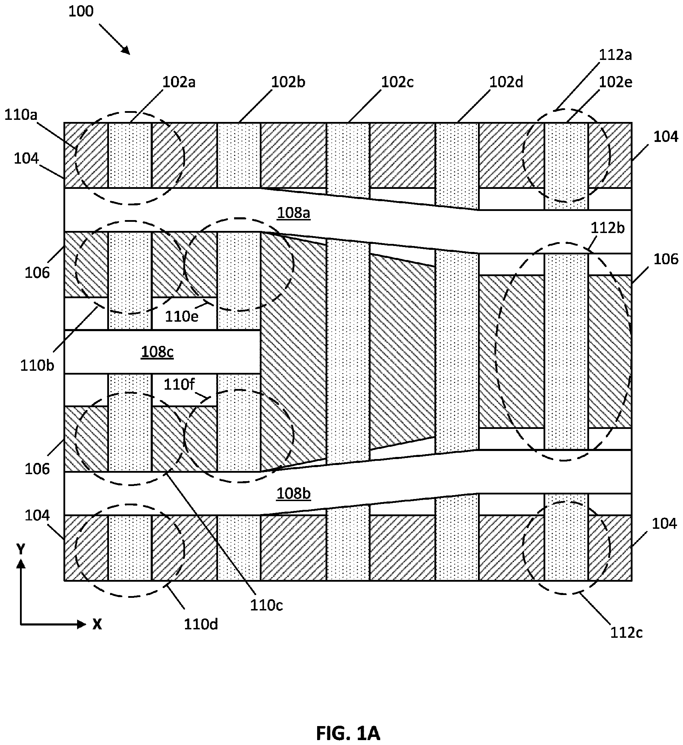

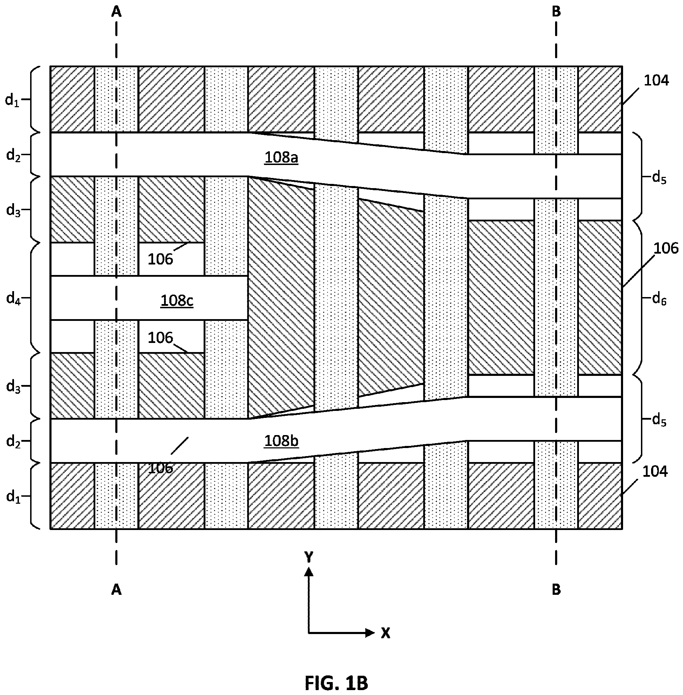

Figure 1A is a plan view of a cell 100 within an integrated circuit structure, according to some embodiments. Cell 100 may be arranged adjacent to any number of other similar cells in an array of rows and columns with cell boundaries identified by the edges of cell 100 as illustrated in Figure 1. It should be understood that the cell boundary does not refer to a specific structure and instead identifies a delineation between repeating transistor arrangements. Each repeating cell 100 contains the same arrangement of transistor structures, according to some embodiments.

According to some embodiments, a given cell 100 includes any number of transistor devices. In some examples, cell 100 includes any number of semiconductor fins having semiconductor regions (e.g., nanoribbons or nanosheets) extending in a first direction between source or drain regions 104 and may also include a wider semiconductor region extending in the first direction between wider source or drain regions 106. Additionally, cell 100 may include any number of parallel gate structures 102a - 102e that run lengthwise along a second direction (e.g., along a height direction of the cell and substantially orthogonal to the first direction). The first direction may extend along an X-axis and the second direction may extend along a Y-axis. In some examples, one or more of gate structures 102a - 102e may be dummy structures or replaced with a dielectric material as these structures may act as barriers to separate adjacent devices. According to some embodiments, source or drain regions 104 at the top and bottom edges of cell 100 are n-type source or drain regions (e.g., silicon doped with phosphorous) and source or drain regions 106 across the middle of cell 100 are p-type source or drain regions (e.g., silicon germanium doped with boron). The opposite doping scheme may be used as well.

According to some embodiments, different types of transistors are formed on different sides of cell 100. For example, a first dielectric wall 108a acts as a dielectric spine between forksheet transistors 110a and 110b on either side of first dielectric wall 108a. These devices are shown on the left side of cell 100. A first gate structure 102a and a second gate structure 102b provide the transistor gates for the forksheet devices formed on the left side of cell 100. According to some embodiments, first dielectric wall 108a angles away from the semiconductor regions as it extends along the first direction. By doing so, first dielectric wall 108a acts as a gate cut between adjacent GAA devices, such as between GAA devices 112a and 112b formed on the right side of cell 100. According to some embodiments, first dielectric wall 108a contacts the semiconductor regions of forksheet transistors 110a and 110b and is separated from the semiconductor regions of GAA devices 112a and 112b by portions of gate structure 102e along the second direction. In an embodiment, first dielectric wall 108a is positioned on a top side of cell 100, and second dielectric wall 108b provides the mirror image arrangement on the bottom side of cell 100. Accordingly, second dielectric wall 108b acts as a dielectric spine between forksheet transistors 110c and 110d on either side of second dielectric wall 108b on the left side of cell 100 and acts as a gate cut between adjacent GAA devices 112b and 112c on the right side of cell 100.

According to some embodiments, the semiconductor regions of the central forksheet transistors (forksheet transistor 110b and its mirrored counterpart forksheet transistor 110c on the opposite side of a third dielectric wall 108c) extend along the first direction and merge into a single larger region as shown on the right side of cell 100. As shown in the illustrated example of Figure 1A, the semiconductor regions may be separate while crossing second gate structure 102b and then are merged into a single region while crossing third gate structure 102c. The semiconductor region remains as a single merged region as it continues to cross each of fourth gate structure 102d and fifth gate structure 102e, according to some embodiments. This merging also creates merged source or drain regions 106 through the middle of cell 100. For example, forksheet transistor 110e includes a semiconductor region extending in the first direction between a first source or drain region on the left and a second merged source or drain region on the right, forksheet transistor 110f includes a semiconductor region extending in the first direction between a third source or drain region on the left and the same second merged source or drain region on the right.

Figure 1B illustrates the same cell layout as shown in Figure 1A with various dimensions identified. According to some embodiments, the semiconductor regions extending between source or drain regions 104 at the top and bottom edges of cell 100 have a width d₁ along the second direction between about 15 nm and about 40 nm, such as around 27 nm. First dielectric wall 108a and second dielectric wall 108b may have a width d₂ along the second direction between about 10 nm and about 20 nm, such as around 14 nm. The semiconductor regions extending between source or drain regions 106 as part of the forksheet transistors on the left side of cell 100 have a width d₃ along the second direction between about 15 nm and about 40 nm, such as around 27 nm. A distance d₄ along the second direction between the forksheet devices on the left side of cell 100 may be between about 25 nm and about 45 nm, such as around 36 nm. A distance d₅ along the second direction between the GAA devices on the right side of cell 100 may be between about 20 nm and about 40 nm, such as around 30 nm. The semiconductor region extending between source or drain regions 106 as part of the GAA devices on the right side of cell 100 may have a width d₆ along the second direction between about 50 nm and about 70 nm, such as around 60 nm. Some of these dimensions may vary depending on the application.

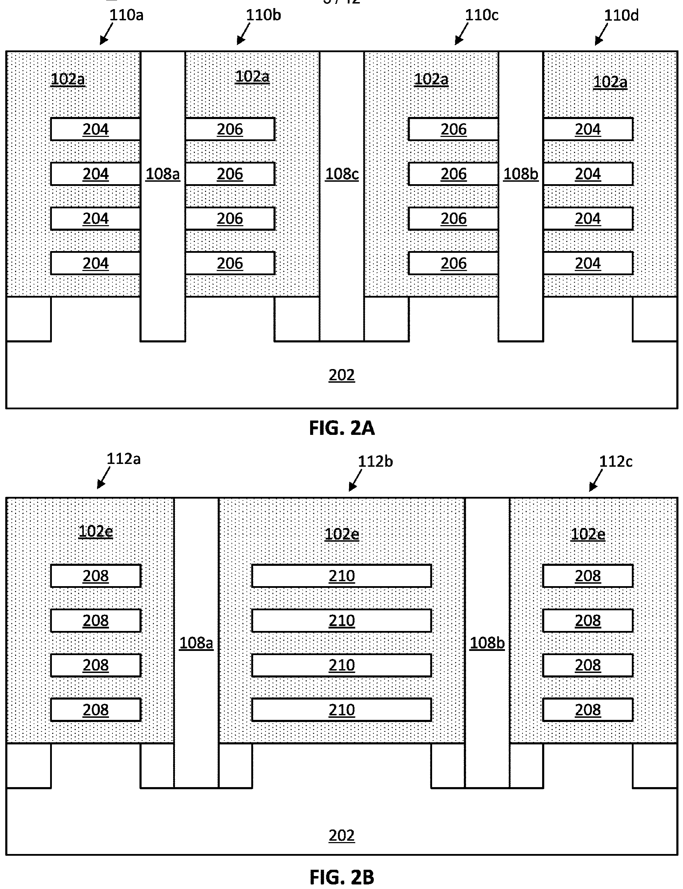

Figures 2A and 2B illustrate cross-section views along the A-A line and B-B line respectively, shown in Figure 1B, according to some embodiments. Thus, Figure 2A illustrates the forksheet devices on the left side of cell 100 and Figure 2B illustrates the GAA devices on the right of cell 100. The various semiconductor devices are formed over a substrate 202. Substrate 202 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 202 can be a semiconductor-on-insulator substrate having a desired semiconductor layer over a buried insulator layer (e.g., silicon over silicon dioxide). Alternatively, substrate 202 can be a multilayer substrate or superlattice suitable for forming nanowires or nanoribbons (e.g., alternating layers of silicon and SiGe, or alternating layers indium gallium arsenide and indium phosphide). Any number of substrates can be used. In some embodiments, substrate 202 is removed and replaced with one or more backside interconnect layers to form backside signal and power routing.

Each transistor includes a semiconductor body extending in the first direction, such as nanosheets 204 of forksheet transistors 110a and 110d, nanosheets 206 of forksheet transistors 110b and 110c, nanoribbons 208 of GAA devices 112a and 112c, and nanoribbons 210 of GAA device 112b. Each vertical set of nanosheets or nanoribbons represents the semiconductor body of a single transistor. According to some embodiments, nanosheets 204 extend in the first direction between n-type source or drain regions and nanosheets 206 extend in the first direction between p-type source or drain regions. Similarly, nanoribbons 208 extend in the first direction between n-type source or drain regions and nanoribbons 210 extend in the first direction between p-type source or drain regions.

It can be observed across both cross-section views how first dielectric wall 108a acts as a dielectric spine between forksheet transistors 110a and 110b and also as a gate cut between GAA devices 112a and 112b. Similarly, second dielectric wall 108b acts as a dielectric spine between forksheet transistors 110c and 110d and also as a gate cut between GAA devices 112b and 112c. When acting as a dielectric spine, no portion of gate structure 102a is between the nanosheets 204/206 and dielectric wall 108a/108b across the second direction, according to some embodiments. When acting as a gate cut, portions of gate structure 102e are present between nanoribbons 208/210 and dielectric wall 108a/108b along the second direction.

According to some embodiments, nanosheets 204 of forksheet transistors 110a and 110d extend along the first direction to become nanoribbons 208 of GAA devices 112a and 112c. According to some embodiments, nanosheets 206 of forksheet transistors 110b and 110c extend along the first direction and eventually merge to become nanoribbons 210 of GAA device 112b. Third dielectric wall 108c is seen separating the forksheet devices along the second direction as seen in Figure 2A, but does not continue to extend along the first direction to separate the GAA devices as seen in Figure 2B.

### Fabrication Methodology

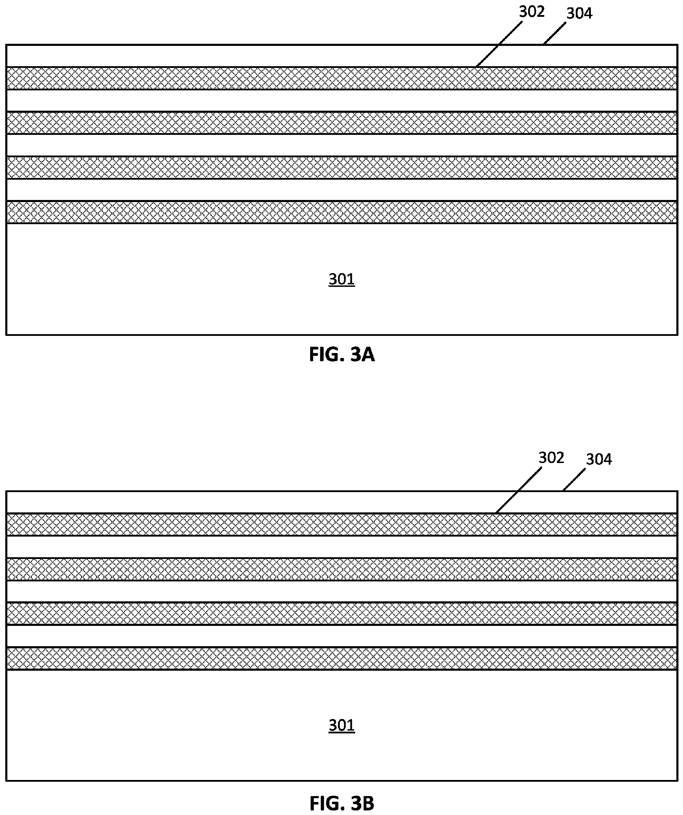

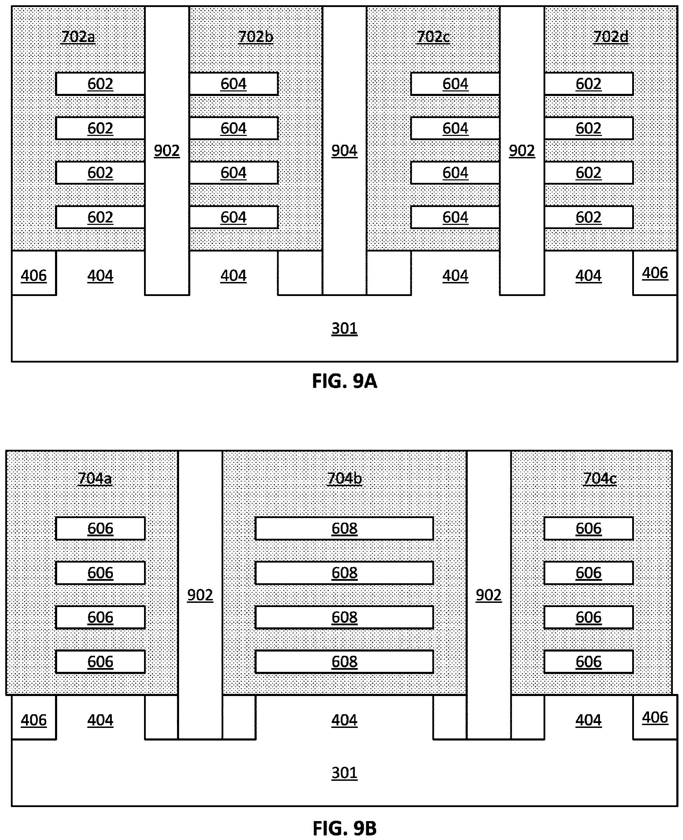

Figures 3A - 9A and 3B - 9B include cross-sectional views that collectively illustrate an example process for forming an integrated circuit that includes a cell having both forksheet devices and GAA devices, in accordance with some embodiments of the present disclosure. Figures 3A - 9A represent a similar cross-sectional view as that of Figure 2A taken across line A-A of the Figure 1B plan view, while Figures 3B - 9B represent a similar cross-sectional view as that of Figure 2B taken across line B-B of the Figure 1B plan view. Each set of figures sharing the same letter shows an example structure that results from the process flow up to that point in time, so the depicted structure evolves as the process flow continues, culminating in the structure shown in Figures 9A and 9B, which is similar to the structure shown in Figures 2A and 2B. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but other materials and process parameters may be used as well, as will be appreciated in light of this disclosure.

Figures 3A and 3B each illustrates a cross-sectional view taken through a substrate 301 having a series of material layers formed over substrate 301, according to an embodiment of the present disclosure. Alternating material layers may be deposited over substrate 301 including sacrificial layers 302 alternating with semiconductor layers 304. The alternating layers are used to form both forksheet and GAA transistor structures. Any number of alternating sacrificial layers 302 and semiconductor layers 304 may be deposited over substrate 301. Substrate 301 may be similar to substrate 202 discussed above.

According to some embodiments, semiconductor layers 304 have a different material composition than sacrificial layers 302. In some embodiments, semiconductor layers 304 include a semiconductor material suitable for use as a nanoribbon such as silicon (Si), SiGe, germanium, or III-V materials like indium phosphide (InP) or gallium arsenide (GaAs). Sacrificial layers 302 include a material that can be selectively removed relative to semiconductor layers 304. In some examples, for instance, semiconductor layers 304 are silicon and sacrificial layers 302 are SiGe, or vice-versa. In some other examples where SiGe is used in each of semiconductor layers 304 and in sacrificial layers 302, the germanium concentration is different between semiconductor layers 304 and sacrificial layers 302, so as to allow for etch selectivity. For example, semiconductor layers 304 may include a higher germanium content compared to sacrificial layers 302.

While dimensions can vary from one example embodiment to the next, the thickness of each semiconductor layer 304 may be between about 5 nm and about 20 nm, such as between about 6 nm and about 10 nm. In some embodiments, the thickness of each semiconductor layer 304 is substantially the same (e.g., within 1 nm). The thickness of each of sacrificial layers 302 may be about the same as the thickness of each semiconductor layer 304 (e.g., about 6 - 10 nm). Each of semiconductor layers 304 and sacrificial layers 302 may be deposited using any material deposition technique, such as chemical vapor deposition (CVD), plasma-enhanced chemical vapor deposition (PECVD), physical vapor deposition (PVD), or atomic layer deposition (ALD), or epitaxial growth.

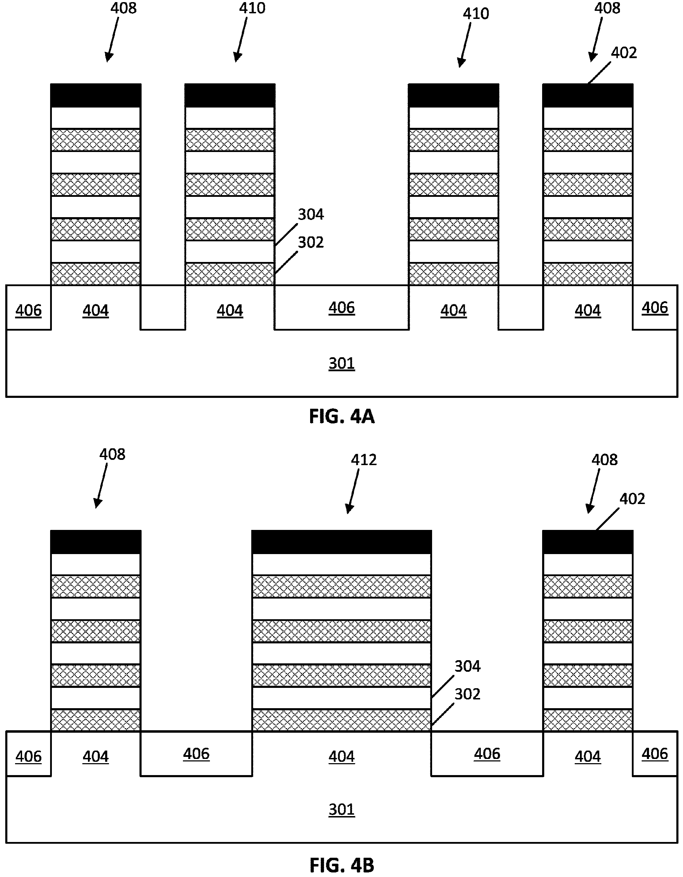

Figures 4A and 4B depict the cross-section views of the structure shown in Figures 3A and 3B, respectively, following the formation of a cap layer 402 and the subsequent formation of fins beneath cap layer 402, according to an embodiment. Cap layer 402 may be any suitable hard mask material such as a carbon hard mask (CHM) or silicon nitride. Cap layer 402 is patterned to form corresponding fins from the alternating layer stack of sacrificial layers 302 and semiconductor layers 304. Cap layer 402 extends along the top of each fin.

According to some embodiments, an anisotropic etching process through the layer stack continues into at least a portion of substrate 301. Portions of substrate 301 beneath the fins are not etched and yield subfin regions 404. The etched portions of substrate 301 that are not under the fins may be filled with a dielectric fill 406 that acts as shallow trench isolation (STI) between adjacent fins. The dielectric fill may be any suitable dielectric material such as silicon dioxide and may be recessed until it is at substantially the same level as subfin regions 404 or below a top surface of subfin regions 404.

Note that fins 408 extend along the first direction and are the same fins observed across both cross-section views. However, fins 410 from the cross-section of Figure 4A merge together as they extend along the first direction (e.g., into the page) to form a wider fin 412 as seen in the cross-section of Figure 4B.

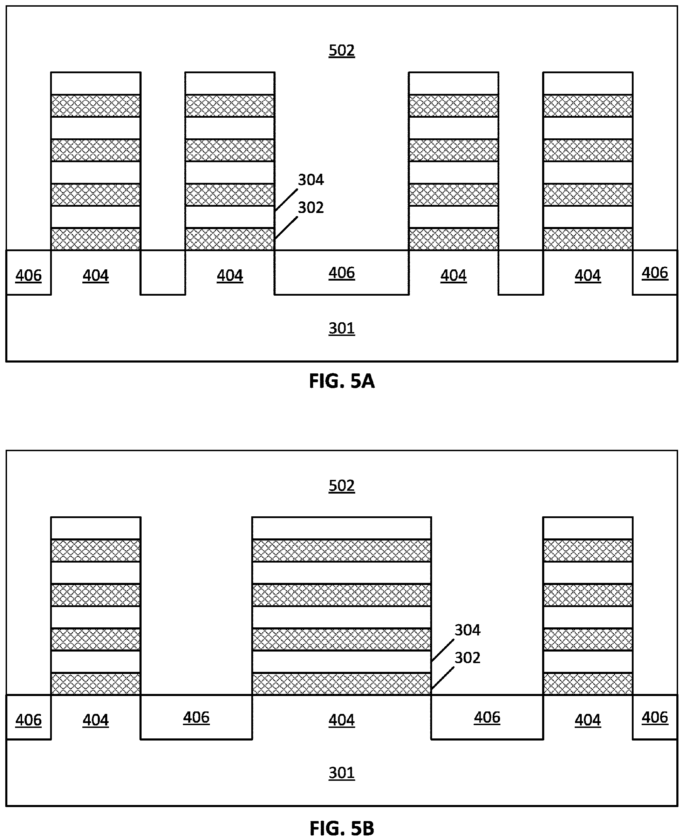

Figures 5A and 5B depict cross-section views of the structures shown in Figures 4A and 4B following the formation of sacrificial gates 502 extending across the fins in a second direction (e.g., across the page) different from the first direction, according to some embodiments. Sacrificial gates 502 may extend across the fins in a second direction that is orthogonal to the first direction. According to some embodiments, the sacrificial gate material is formed in parallel strips across the integrated circuit and removed in all areas not protected by a gate masking layer. Sacrificial gates 502 may be any suitable material that can be selectively removed without damaging the semiconductor material of the fins. In some examples, sacrificial gates 502 include polysilicon.

Following the formation of sacrificial gates 502 (and prior to replacement of sacrificial gates 502 with a metal gate), additional semiconductor device structures are formed that are not shown in these cross-sections. These additional structures include spacer structures on the sidewalls of sacrificial gates 502 and source and drain regions on either ends of each of the fins. The formation of such structures can be accomplished using any number of processing techniques.

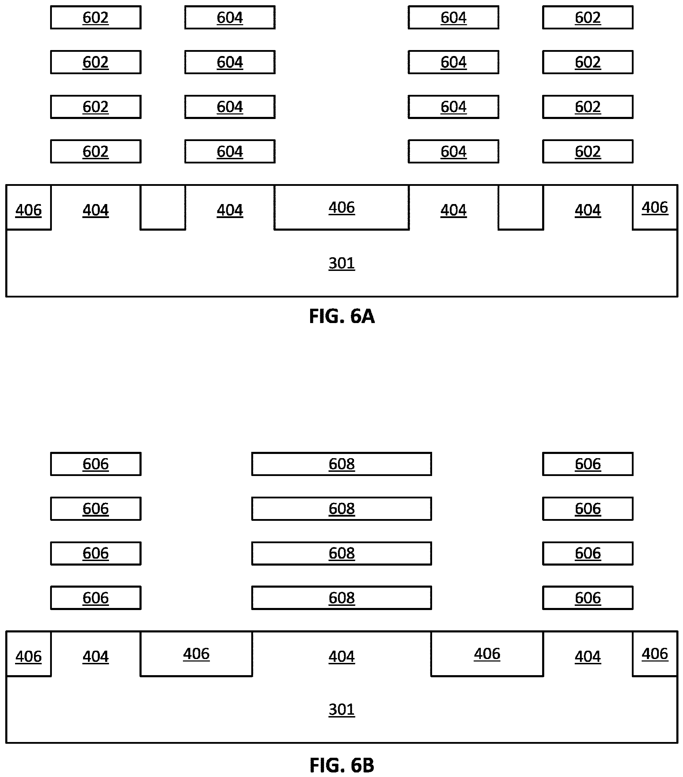

Figures 6A and 6B depict cross-section views of the structures shown in Figures 5A and 5B following the removal of sacrificial gates 502, according to some embodiments. In examples where any gate masking layers are still present, they may also be removed at this time. Once sacrificial gates 502 are removed, the fins that had been beneath sacrificial gates 502 are exposed.

According to some embodiments, the same isotropic etching process used to remove sacrificial gates 502 (or a different isotropic etching process) is used to also remove sacrificial layers 302 from the fins, thus releasing various sets of nanoribbons. For example, nanoribbons 602 and 606 may extend in the first direction between n-type source or drain regions, nanoribbons 604 may extend in the first direction between p-type source or drain regions, and wider nanoribbons 608 may extend in the first direction between p-type source or drain regions. Each vertical set of nanoribbons represents the semiconductor or channel region of a different semiconductor device. Any suitable isotropic etching process may be used to remove sacrificial layers 302 while removing little to none of semiconductor layers 304.

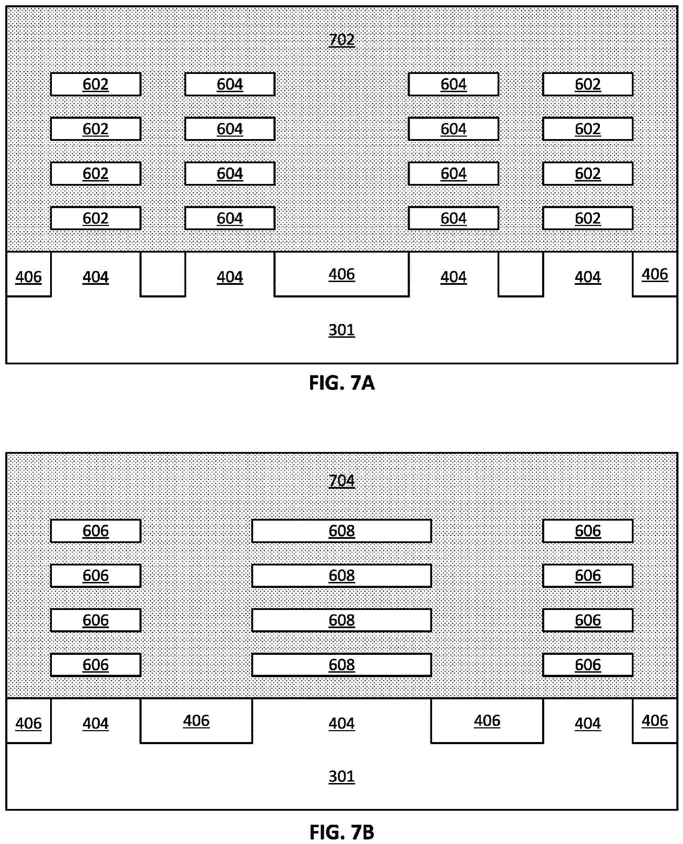

Figures 7A and 7B depict cross-section views of the structures shown in Figures 6A and 6B following the formation of gate structures 702/704 and subsequent polishing, according to some embodiments. Gate structures 702/704 each include a gate dielectric and a conductive gate electrode on the gate dielectric. The gate dielectric may be first formed around the various nanoribbons prior to the formation of the gate electrode. The gate dielectric may include any suitable dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the gate dielectric includes a layer of hafnium oxide with a thickness between about 1 nm and about 5 nm. In some embodiments, the gate dielectric may include one or more silicates (e.g., titanium silicate, tungsten silicate, niobium silicate, and silicates of other transition metals). In some cases, the gate dielectric may include a first layer on the nanoribbons, and a second layer on the first layer. The first layer can be, for instance, an oxide of the semiconductor material of the nanoribbons (e.g., silicon dioxide) and the second layer can be a high-k dielectric material (e.g., hafnium oxide). More generally, the gate dielectric can include any number of dielectric layers. According to some embodiments, the gate dielectric forms along all surfaces exposed within the gate trench, such as along inner sidewalls of the spacer structures and along the top surfaces of subfins 404.

The one or more conductive layers that make up the gate electrode may be deposited using electroplating, electroless plating, CVD, PECVD, ALD, or PVD, to name a few examples. In some embodiments, the gate electrode includes doped polysilicon, a metal, or a metal alloy. Example suitable metals or metal alloys include aluminum, tungsten, cobalt, molybdenum, ruthenium, titanium, tantalum, copper, and carbides and nitrides thereof. The gate electrode may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates.

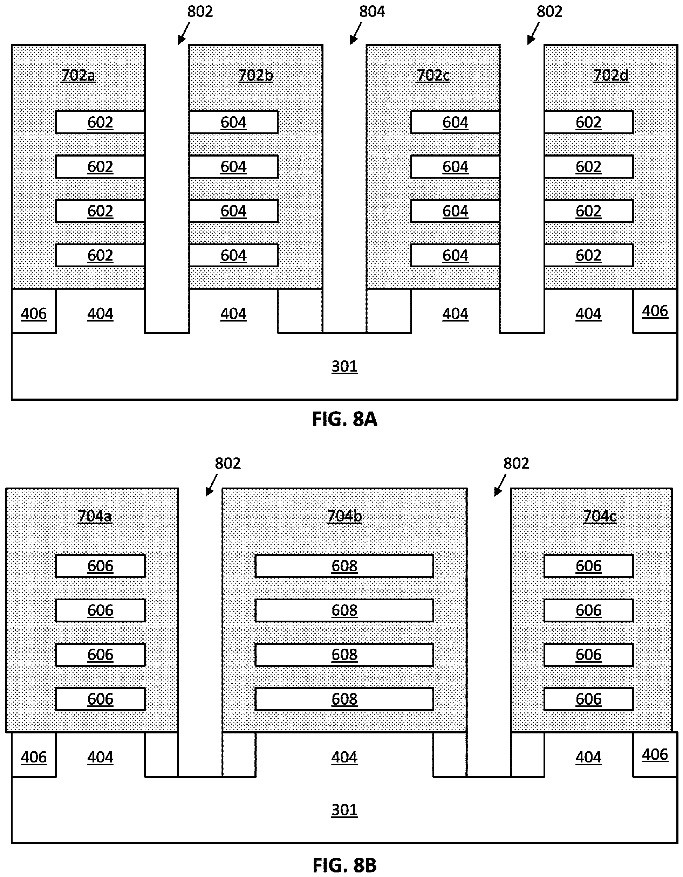

Figures 8A and 8B depict cross-section views of the structures shown in Figures 7A and 7B following the formation of trench recesses 802 and 804 through portions of the gate structures 702/704, according to some embodiments. Trench recesses 802 may extend in a third direction (e.g., height direction) through at least an entire thickness of gate structure 702 and directly adjacent to nanoribbons 602 and 604 such that the nanoribbons 602/604 become nanosheets 602/604 of forksheet transistors. According to some embodiments, trench recesses 802 extend along the first direction and angle inwards to also extend through an entire thickness of gate structure 704, but spaced away from nanoribbons 606 and nanoribbons 608 along the second direction. Another trench recess 804 may also be formed through at least an entire thickness of gate structure 702 and between nanosheets 604. Trench recess 804 is spaced from nanosheets 604 along the second direction and does not extend along the first direction to cross gate structure 704. The presence of trench recesses 802 and 804 may separate gate structure 702 into four distinct gate structures 702a - 704d and may separate gate structure 704 into three distinct gates structures 704a - 704c.

Trench recesses 802 and 804 may be formed at the same time using a reaction ion etching (RIE) process to cut through the various material (while protecting the other regions using a patterned masking layer). Trench recesses 802 and 804 may extend into at least a portion of dielectric fill 406 between subfin regions 404. In some examples, trench recesses 802 and 804 extend into at least a portion of substrate 301.

Figures 9A and 9B depict cross-section views of the structures shown in Figures 8A and 8B following the formation of dielectric walls 902 and 904 within trench recesses 802 and 804, respectively, according to some embodiments. Dielectric walls 902 act both as dielectric spines between nanoribbons 602 and 604 of the forksheet devices in Figure 9A and also as gate cuts between nanoribbons 606 and 608 of the GAA devices in Figure 9B. Dielectric wall 904 acts as a gate cut between the forksheet devices in Figure 9A.

Each of dielectric walls 902 and 904 may be formed from any number of dielectric materials. In some examples, dielectric walls 902 and 904 include the same dielectric material and are filled during the same dielectric deposition process or processes. In some embodiments, dielectric wall 904 includes a different dielectric material compared to dielectric walls 902. According to some embodiments, dielectric walls 902 and 904 include a first dielectric layer deposited first and a second dielectric layer or dielectric fill formed on the first dielectric layer. The first dielectric layer may include a high-k dielectric material (e.g., materials with a dielectric constant higher than that of silicon oxide or higher than 3.9, such as silicon nitride) while the second dielectric layer may include a low-k dielectric material (e.g. materials with a dielectric constant equal to or lower than that of silicon oxide, such as porous silicon oxide, or equal to or lower than 3.9). In some embodiments, dielectric walls 902 and 904 include only silicon nitride, only silicon oxynitride, or only silicon oxycarbide.

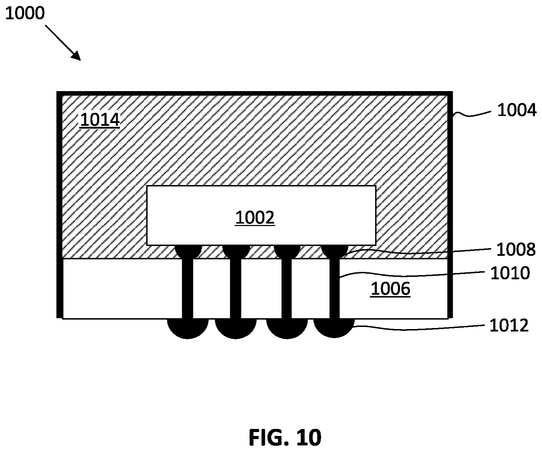

Figure 10 illustrates an example embodiment of a chip package 1000, in accordance with an embodiment of the present disclosure. As can be seen, chip package 1000 includes one or more dies 1002. One or more dies 1002 may include at least one integrated circuit having semiconductor devices, such as any of the semiconductor devices disclosed herein. One or more dies 1002 may include any other circuitry used to interface with other devices formed on the dies, or other devices connected to chip package 1000, in some example configurations.

As can be further seen, chip package 1000 includes a housing 1004 that is bonded to a package substrate 1006. The housing 1004 may be any standard or proprietary housing, and may provide, for example, electromagnetic shielding and environmental protection for the components of chip package 1000. The one or more dies 1002 may be conductively coupled to a package substrate 1006 using connections 1008, which may be implemented with any number of standard or proprietary connection mechanisms, such as solder bumps, ball grid array (BGA), pins, or wire bonds, to name a few examples. Package substrate 1006 may be any standard or proprietary package substrate, but in some cases includes a dielectric material having conductive pathways (e.g., including conductive vias and lines) extending through the dielectric material between the faces of package substrate 1006, or between different locations on each face. In some embodiments, package substrate 1006 may have a thickness less than 1 millimeter (e.g., between 0.1 millimeters and 0.5 millimeters), although any number of package geometries can be used. Additional conductive contacts 1012 may be disposed at an opposite face of package substrate 1006 for conductively contacting, for instance, a printed circuit board (PCB). One or more vias 1010 extend through a thickness of package substrate 1006 to provide conductive pathways between one or more of connections 1008 to one or more of contacts 1012. Vias 1010 are illustrated as single straight columns through package substrate 1006 for ease of illustration, although other configurations can be used (e.g., damascene, dual damascene, through-silicon via, or an interconnect structure that meanders through the thickness of substrate 1006 to contact one or more intermediate locations therein). In still other embodiments, vias 1010 are fabricated by multiple smaller stacked vias, or are staggered at different locations across package substrate 1006. In the illustrated embodiment, contacts 1012 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1012, to inhibit shorting.

In some embodiments, a mold material 1014 may be disposed around the one or more dies 1002 included within housing 1004 (e.g., between dies 1002 and package substrate 1006 as an underfill material, as well as between dies 1002 and housing 1004 as an overfill material). Although the dimensions and qualities of the mold material 1014 can vary from one embodiment to the next, in some embodiments, a thickness of mold material 1014 is less than 1 millimeter. Example materials that may be used for mold material 1014 include epoxy mold materials, as suitable. In some cases, the mold material 1014 is thermally conductive, in addition to being electrically insulating.

### Example System

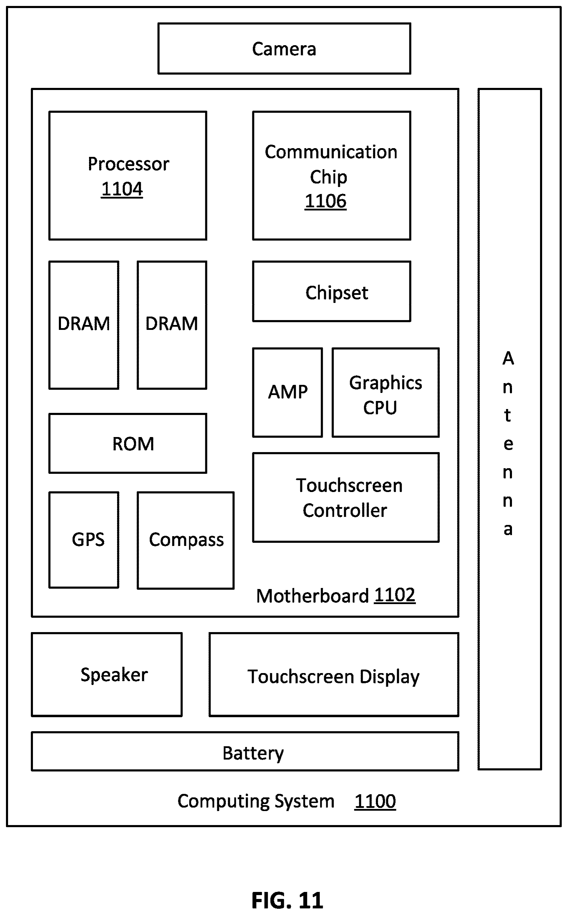

FIG. 11 is an example computing system implemented with one or more of the integrated circuit structures as disclosed herein, in accordance with some embodiments of the present disclosure. As can be seen, the computing system 1100 houses a motherboard 1102. The motherboard 1102 may include a number of components, including, but not limited to, a processor 1104 and at least one communication chip 1106, each of which can be physically and electrically coupled to the motherboard 1102, or otherwise integrated therein. As will be appreciated, the motherboard 1102 may be, for example, any printed circuit board (PCB), whether a main board, a daughterboard mounted on a main board, or the only board of system 1100, etc.

Depending on its applications, computing system 1100 may include one or more other components that may or may not be physically and electrically coupled to the motherboard 1102. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1100 may include one or more integrated circuit structures or devices configured in accordance with an example embodiment (e.g., a module including an integrated circuit device on a substrate, the substrate having one or more cells that include both GAA devices and forksheet devices, as variously provided herein). In some embodiments, multiple functions can be integrated into one or more chips (e.g., for instance, note that the communication chip 1106 can be part of or otherwise integrated into the processor 1104).

The communication chip 1106 enables wireless communications for the transfer of data to and from the computing system 1100. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1106 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1100 may include a plurality of communication chips 1106. For instance, a first communication chip 1106 may be dedicated to shorter range wireless communications such as Wi-Fi and Bluetooth and a second communication chip 1106 may be dedicated to longer range wireless communications such as GPS, EDGE, GPRS, CDMA, WiMAX, LTE, Ev-DO, and others.

The processor 1104 of the computing system 1100 includes an integrated circuit die packaged within the processor 1104. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1106 also may include an integrated circuit die packaged within the communication chip 1106. In accordance with some such example embodiments, the integrated circuit die of the communication chip includes one or more semiconductor devices as variously described herein. As will be appreciated in light of this disclosure, note that multistandard wireless capability may be integrated directly into the processor 1104 (e.g., where functionality of any chips 1106 is integrated into processor 1104, rather than having separate communication chips). Further note that processor 1104 may be a chip set having such wireless capability. In short, any number of processor 1104 and/or communication chips 1106 can be used. Likewise, any one chip or chip set can have multiple functions integrated therein.

In various implementations, the computing system 1100 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1100 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first semiconductor device having a first semiconductor region extending from a first source or drain region in a first direction and a first gate structure extending in a second direction over the first semiconductor region, a second semiconductor device having a second semiconductor region extending in the first direction from a second source or drain region and a second gate structure extending in the second direction over the second semiconductor region, and a dielectric wall having a first section extending in the first direction adjacent to and contacting the first semiconductor region, and a second section extending in the first direction adjacent to but not contacting the second semiconductor region. The second gate structure is between the second semiconductor region and the second section of the dielectric wall along the second direction.

Example 2 includes the integrated circuit of Example 1, wherein the dielectric wall comprises silicon and nitrogen.

Example 3 includes the integrated circuit of Example 1 or 2, wherein the first section of the dielectric wall has a first width along the second direction, and the second section of the dielectric wall has a second width along the second direction that is substantially equal to the first width.

Example 4 includes the integrated circuit of Example 3, wherein the first width is between about 10 nm and about 20 nm.

Example 5 includes the integrated circuit of any one of Examples 1-4, wherein the first semiconductor region comprises a plurality of semiconductor nanosheets and the second semiconductor region comprises a plurality of semiconductor nanoribbons.

Example 6 includes the integrated circuit of Example 5, wherein the plurality of semiconductor nanosheets and the plurality of semiconductor nanoribbons comprise germanium, silicon, or a combination thereof.

Example 7 includes the integrated circuit of any one of Examples 1-6, further including a third semiconductor device having a third semiconductor region extending from a third source or drain region in the first direction, and a third gate structure extending in the second direction over the third semiconductor region, and a fourth semiconductor device having a fourth semiconductor region extending from a fourth source or drain region in the first direction, and a fourth gate structure extending in the second direction over the fourth semiconductor region. The dielectric wall is between and contacting both the first semiconductor region and the third semiconductor region along the second direction and is between both the second semiconductor region and the fourth semiconductor region along the second direction.

Example 8 includes the integrated circuit of Example 7, wherein the third semiconductor region has a first width along the second direction, and the fourth semiconductor region has a second width along the second direction that is greater than the first width.

Example 9 includes the integrated circuit of Example 8, wherein the first width is between about 20 nm and about 40 nm, and the second width is between about 50 nm and about 70 nm.

Example 10 includes the integrated circuit of any one of Examples 7-9, wherein a first distance between the first semiconductor region and the third semiconductor region along the second direction is less than a second distance between the second semiconductor region and the fourth semiconductor region along the second direction.

Example 11 includes the integrated circuit of Example 10, wherein the first distance is between about 10 nm and about 20 nm, and the second distance is between about 20 nm and about 40 nm.

Example 12 includes the integrated circuit of any one of Examples 1-11, wherein the second direction is substantially perpendicular to the first direction.

Example 13 is a die that includes the integrated circuit of any one of Examples 1-12.

Example 14 is an electronic device that includes a chip package having one or more dies. At least one of the one or more dies includes a first semiconductor region extending from a first source or drain region in a first direction, a first gate structure extending over the first semiconductor region in a second direction, a second semiconductor region extending in the first direction from a second source or drain region, a second gate structure extending in the second direction over the second semiconductor region, and a dielectric wall having a first section extending in the first direction adjacent to and contacting the first semiconductor region, and a second section extending in the first direction adjacent to but not contacting the second semiconductor region. The second gate structure is between the second semiconductor region and the second section of the dielectric wall along the second direction.

Example 15 includes the electronic device of Example 14, wherein the dielectric wall comprises silicon and nitrogen.

Example 16 includes the electronic device of Example 14 or 15, wherein the first section of the dielectric wall has a first width along the second direction, and the second section of the dielectric wall has a second width along the second direction that is substantially the same as the first width.

Example 17 includes the electronic device of Example 16, wherein the first width is between about 10 nm and about 20 nm.

Example 18 includes the electronic device of any one of Examples 14-17, wherein the first semiconductor region comprises a plurality of semiconductor nanosheets and the second semiconductor region comprises a plurality of semiconductor nanoribbons.

Example 19 includes the electronic device of Example 18, wherein the plurality of semiconductor nanosheets and the plurality of semiconductor nanoribbons comprise germanium, silicon, or a combination thereof.

Example 20 includes the electronic device of any one of Examples 14-19, wherein the at least one of the one or more dies further includes a third semiconductor device having a third semiconductor region extending from a third source or drain region in the first direction, and a third gate structure extending in the second direction over the third semiconductor region, and a fourth semiconductor device having a fourth semiconductor region extending from a fourth source or drain region in the first direction, and a fourth gate structure extending in the second direction over the fourth semiconductor region. The dielectric wall is between and contacting both the first semiconductor region and the third semiconductor region along the second direction and is between both the second semiconductor region and the fourth semiconductor region along the second direction.

Example 21 includes the electronic device of Example 20, wherein the third semiconductor region has a first width along the second direction, and the fourth semiconductor region has a second width along the second direction that is greater than the first width.

Example 22 includes the electronic device of Example 21, wherein the first width is between about 20 nm and about 40 nm, and the second width is between about 50 nm and about 70 nm.

Example 23 includes the electronic device of any one of Examples 20-22, wherein a first distance between the first semiconductor region and the third semiconductor region along the second direction is less than a second distance between the second semiconductor region and the fourth semiconductor region along the second direction.

Example 24 includes the electronic device of Example 23, wherein the first distance is between about 10 nm and about 20 nm, and the second distance is between about 20 nm and about 40 nm.

Example 25 includes the electronic device of any one of Examples 14-24, wherein the second direction is substantially perpendicular to the first direction.

Example 26 includes the electronic device of any one of Examples 14-25, further comprising a printed circuit board, wherein the chip package is directly coupled to the printed circuit board.

Example 27 is an integrated circuit that includes a first semiconductor device having a first semiconductor region extending from a first source or drain region in a first direction and a first gate structure extending in a second direction over the first semiconductor region, a second semiconductor device having a second semiconductor region extending in the first direction from a second source or drain region and a second gate structure extending in the second direction over the second semiconductor region, a dielectric wall extending in the first direction between the first semiconductor region and the second semiconductor region and between the first source or drain region and the second source or drain region, and a third semiconductor device having a third semiconductor region extending in the first direction from a third source or drain region and a third gate structure extending in the second direction over the third semiconductor region. The second source or drain region is adjacent to the first source or drain region along the second direction. The first semiconductor region extends in the first direction from the first source or drain region to the third source or drain region, and the second semiconductor region extends in the first direction from the second source or drain region to the third source or drain region.

Example 28 includes the integrated circuit of Example 27, wherein the dielectric wall comprises silicon and nitrogen.

Example 29 includes the integrated circuit of Example 27 or 28, wherein the first semiconductor region comprises a plurality of first semiconductor nanosheets, the second semiconductor region comprises a plurality of second semiconductor nanosheets, and the third semiconductor region comprises a plurality of semiconductor nanoribbons.

Example 30 includes the integrated circuit of Example 29, wherein the plurality of first semiconductor nanosheets, the plurality of second semiconductor nanosheets, and the plurality of semiconductor nanoribbons comprise germanium, silicon, or a combination thereof.

Example 31 includes the integrated circuit of any one of Examples 27-30, wherein the first semiconductor region and the second semiconductor region have substantially the same width along the second direction.

Example 32 includes the integrated circuit of Example 31, wherein the first semiconductor region and the second semiconductor region have a first width along the second direction and the third semiconductor region has a second width along the second direction that is greater than the first width.

Example 33 includes the integrated circuit of Example 32, wherein the first width is between about 20 nm and about 40 nm, and the second width is between about 50 nm and about 70 nm.

Example 34 includes the integrated circuit of any one of Examples 27-33, wherein a distance between the first semiconductor region and the second semiconductor region along the second direction is between about 25 nm and about 45 nm.

Example 35 includes the integrated circuit of any one of Examples 27-34, wherein the second direction is substantially perpendicular to the first direction.

Example 36 is a die that includes the integrated circuit of any one of Examples 27-35.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor device having a first semiconductor region extending from a first source or drain region in a first direction, and a first gate structure extending over the first semiconductor region, the first gate structure extending in a second direction over the first semiconductor region;
a second semiconductor device having a second semiconductor region extending in the first direction from a second source or drain region, and a second gate structure extending in the second direction over the second semiconductor region; and
a dielectric wall having a first section extending in the first direction adjacent to and contacting the first semiconductor region, and a second section extending in the first direction adjacent to but not contacting the second semiconductor region, such that the second gate structure is between the second semiconductor region and the second section of the dielectric wall along the second direction.

2. The integrated circuit of claim 1, wherein the dielectric wall comprises silicon and nitrogen.

3. The integrated circuit of claim 1 or 2, wherein the first section of the dielectric wall has a first width along the second direction, and the second section of the dielectric wall has a second width along the second direction that is substantially equal to the first width.

4. The integrated circuit of claim 3, wherein the first width is between about 10 nm and about 20 nm.

5. The integrated circuit of any one of claims 1 through 4, wherein the first semiconductor region comprises a plurality of semiconductor nanosheets and the second semiconductor region comprises a plurality of semiconductor nanoribbons.

6. The integrated circuit of claim 5, wherein the plurality of semiconductor nanosheets and the plurality of semiconductor nanoribbons comprise germanium, silicon, or a combination thereof.

7. The integrated circuit of any one of claims 1 through 6, further comprising:
a third semiconductor device having a third semiconductor region extending from a third source or drain region in the first direction, and a third gate structure extending in the second direction over the third semiconductor region, wherein the dielectric wall is between and contacting both the first semiconductor region and the third semiconductor region along the second direction; and
a fourth semiconductor device having a fourth semiconductor region extending from a fourth source or drain region in the first direction, and a fourth gate structure extending in the second direction over the fourth semiconductor region, wherein the dielectric wall is between both the second semiconductor region and the fourth semiconductor region along the second direction.

8. The integrated circuit of claim 7, wherein the third semiconductor region has a first width along the second direction, and the fourth semiconductor region has a second width along the second direction that is greater than the first width.

9. The integrated circuit of claim 8, wherein the first width is between about 20 nm and about 40 nm, and the second width is between about 50 nm and about 70 nm.

10. The integrated circuit of any one of claims 7 through 9, wherein a first distance between the first semiconductor region and the third semiconductor region along the second direction is less than a second distance between the second semiconductor region and the fourth semiconductor region along the second direction.

11. The integrated circuit of claim 10, wherein the first distance is between about 10 nm and about 20 nm, and the second distance is between about 20 nm and about 40 nm.

12. The integrated circuit of any one of claims 1 through 11, wherein the second direction is substantially perpendicular to the first direction.

13. A die comprising the integrated circuit of any one of claims 1 through 12.

14. An integrated circuit comprising:
a first semiconductor device having a first semiconductor region extending from a first source or drain region in a first direction, and a first gate structure extending over the first semiconductor region, the first gate structure extending in a second direction over the first semiconductor region;
a second semiconductor device having a second semiconductor region extending in the first direction from a second source or drain region, and a second gate structure extending in the second direction over the second semiconductor region, the second source or drain region being adjacent to the first source or drain region along the second direction;
a dielectric wall extending in the first direction between the first semiconductor region and the second semiconductor region, and between the first source or drain region and the second source or drain region; and
a third semiconductor device having a third semiconductor region extending in the first direction from a third source or drain region, and a third gate structure extending in the second direction over the third semiconductor region, wherein the first semiconductor region extends in the first direction from the first source or drain region to the third source or drain region, and the second semiconductor region extends in the first direction from the second source or drain region to the third source or drain region.

15. The integrated circuit of claim 15, wherein the first semiconductor region and the second semiconductor region have substantially the same width along the second direction, wherein the first semiconductor region and the second semiconductor region have a first width along the second direction and the third semiconductor region has a second width along the second direction that is greater than the first width.
